Europäisches Patentamt

European Patent Office

Office européen des brevets

(11) Publication number: **0 052 911**
**B1**

(12) **EUROPEAN PATENT SPECIFICATION**

(45) Date of publication of patent specification: **18.09.85**

(21) Application number: **81301106.1**

(22) Date of filing: **17.03.81**

(51) Int. Cl.⁴: **C 30 B 29/52,** C 22 C 19/05, C 30 B 11/00

(54) **Single crystal (single grain) alloy.**

(30) Priority: **24.11.80 US 209501**

(43) Date of publication of application:
**02.06.82 Bulletin 82/22**

(45) Publication of the grant of the patent:
**18.09.85 Bulletin 85/38**

(84) Designated Contracting States:
**BE DE FR GB IT**

(56) References cited:
**FR-A-2 143 065**
**FR-A-2 374 427**
**FR-A-2 392 129**
**GB-A-1 260 982**

(73) Proprietor: **CANNON-MUSKEGON CORPORATION**
**2875 Lincoln Street**
**Muskegon Michigan (US)**

(72) Inventor: **Harris, Kenneth**
**18864 Fruitport Road**
**Spring Lake Michigan (US)**
Inventor: **Erickson, Gary Lee**
**874 West Street**
**Muskegon Michigan (US)**

(74) Representative: **Robinson, Anthony John Metcalf et al**
**Kilburn & Strode 30 John Street**
**London, WC1N 2DD (GB)**

## Description

This invention relates to single crystal alloys for high stress, high temperature application under conditions of long and continuous operation and to turbine blades cast from the alloys.

Alloys of this type are particularly essential in turbine blade technology in which resistance to oxidation and high temperature corrosion combined with high thermal fatigue and high creep strengths are essential. These alloys are commonly referred to as "superalloys".

The concept of alloys for casting single crystal parts was developed several years ago and its development can in part be followed in United States Patent 3 494 709, 4 116 723 and 4 209 348. In addition to the alloys, process technology has been developed for the casting of single crystal alloy parts which prevent the growth of all grain structures except one. The techniques involved in such technology are not part of this invention, rather the invention being the development of an alloy which can be used with such techniques.

In the making of single crystal alloy parts, the part is first cast from an alloy suitable for single crystal technology. Process methods are employed during casting solidification to ensure only one grain forms in the mould cavity, which in fact, forms the part being cast such as a turbine blade. The resulting single crystal casting will, however, not be homogeneous because of substantial "coring" (dendritic segregation) of some of its elements. To eliminate this condition, the casting is subsequently heat treated. In so doing the casting must be heated to a sufficiently high temperature where all of the primary gamma prime strengthening precipitate and some of the eutectic goes into solution. This temperature, however, must be below that at which the casting starts to melt, i.e. the incipient melting point. The temperature range at which this can be accomplished may be called the "heat treatment window". The wider the "window", the greater the possibility that the heat treatment will be successful in solutioning all the primary gamma prime and some of the eutectic without incipient melting occurring. To the extent that there is a failure to solution all of the primary gamma prime in the final casting, there will be a reduction in high temperature strength. If the incipient melting point is reached, there will be a loss of ductility and likelihood of premature creep or fatigue failure due to void formation.

The single crystal alloys heretofore developed, have all had undesirable characteristics. If they had the desired resistance to high temperature fatigue and creep coupled with good oxidation and corrosion resistance, they had such a narrow heat treatment "window" that they were virtually impractical to heat treat on a production basis and lacked dependable repeatability. When it was attempted to widen the heat treatment "window", one of the alloys developed high temperature phase instability which resulted in the formation of plate-like/acicular phase of alphatungsten, alphachromium and mu phase. This has been found to be a progressive condition resulting in deterioration of long time creep and fatigue properties, once the formation of these conditions has been initiated.

The invention creates new alloys which have been proven by tests to develop a relatively wide "window", in the range of at least four to five times as wide as any previously obtained without sacrifice of the operating characteristics essential to maximum performance including creep strength and resistance to thermal fatigue, corrosion and oxidation. Microscopic examination reveals a higher degree of homogenization than heretofore obtained coupled with resistance to high temperature formation of deleterious phase precipitates such as alphatungsten, alphachromium and mu. These characteristics stem in part from the widening of the "window" and in part from an alloy formulation which stabilizes the casting against high temperature, high stress deleterious phase precipitation.

Figure 1 is a photomicrograph taken at 100× of a section in the as-cast condition taken from a single crystal turbine blade cast from the alloy of this invention;

Figure 1A is a photomicrograph of the same section taken at 400×;

Figure 2 is a photomicrograph taken at 100× of a section of an identical turbine blade after solution heat treatment;

Figure 2A is a photomicrograph of the same section as Figure 2 taken at 400×; and

Figure 3 is a graph comparing the high temperature/stress characteristics of the NasAir 100 alloy with those of the alloy of this invention.

In preparing the alloy of this invention, the concept of eliminating the so-called grain boundary strengthening elements has been retained from earlier known, single crystal alloys. Thus, to the extent possible, carbon, zirconium, hafnium and boron have been eliminated. However, the remaining elements have been rebalanced resulting in a formulation which has simultaneously eliminated both the problem of an excessively narrow heat treatment "window" and the problem of high temperature phase instability.

The following single crystal alloy has been developed from first principles, the composition being expressed as percentage of weight:

| Co | Cr | Mo | W | Ta | Al | Ti | Ni |
|----|----|----|----|----|----|-----|-----|
| 5  | 10 | 0  | 4  | 12 | 5  | 1.5 | Bal |

This alloy proved to have the requisite properties of creep strength, corrosion resistance, resistance to thermal fatigue and oxidation. However, it has proven to be very difficult to utilize because it reportedly has a "heat treatment window" limited to a range of 5 degrees to 15 degrees C. Thus, in heat treating this alloy to solution the primary gamma prime, the recommended solution temperature is 1285°C±2.7°C, a virtually impossible range to maintain in production even with very sophisticated equipment. Thus, the rejection rate of the heat treated castings due to incipient melting has been excessive.

To overcome the restrictions imposed by the excessively narrow "heat treatment window" of the above initial single crystal alloy, the MAR M 247 alloy was modified by AiResearch Manufacturing Co.

Starting out with the equiaxe and directional casting (DS) alloy known to the trade as MAR M 247 having the composition by percentage of weight:

| Co | Cr | Mo | W | Ta | Al | Ti | Hf | C | Ni |
|---|---|---|---|---|---|---|---|---|---|
| 10 | 8.2 | 0.6 | 10 | 3 | 5.5 | 1.0 | 1.5 | .16 | Bal |

AiResearch produced a single crystal alloy having a "heat treatment window" of a practical range. This alloy, known as NasAir 100, had the composition expressed as percentage of weight:

| Co | Cr | Mo | W | Ta | Al | Ti | Ni |
|---|---|---|---|---|---|---|---|
| 0 | 9 | 1 | 10.5 | 3.3 | 5.75 | 1.2 | Bal |

The resulting alloy had the desired "heat treatment window" range but upon exposure to high thermal and stress conditions it proved to be unstable. Under these conditions deleterious plate-like and acicular formations of alphatungsten and mu and to a lesser degree alpha-chromium began to appear. These rapidly multiplied to a point such that the thermal fatigue resistance and long term creep strength were materially adversely affected. The thermal phase instability of this alloy will eliminate its utility as a superalloy.

The results of these alloy compositions have, in effect, limited the single crystal alloys intended for usage in situations which approach the outer parameters of thermal/stress operation to those castings of the initial, single crystal alloy which managed to survive the heat treatment process.

After many months of analysis and study of the causes and related effects of the prior single crystal alloy compositions, and using MAR M 247 as the base composition, it was believed that certain heretofore accepted metallurgical concepts in this field were not entirely valid. It had been considered that at least one percent of molybdenum was necessary to maintain the characteristic of a wide "window" but the presence of this element at this level was considered to be one of the significant factors in creating phase instability (mu contains Mo and W) in this type of grain boundary free casting. It was discovered that a half percent of molybdenum could be added to maintain the wide heat treatment without encountering the instability problem. Further, a relatively high tungsten content was considered essential to provide strength and a high chromium content to provide corrosion resistance. It was determined by experimentation that the quantities of both of these elements could be reduced and substituted with tantalum, without loss of the desired strength and oxidation/corrosion resistance characteristics at the upper extreme of the alloy's operating range. This substitution of Ta for W and Cr was also hoped to further improve the alloy's stability, i.e. prevent alphatungsten and alphachromium and mu phase formation. Later tests established the success of this substitution. Cobalt was also added to increase the alloy's solid solubility. Aluminium and titanium contents were left at the same levels as in MAR M 247 alloy. The result of this work was an alloy of the following composition expressed as percentage of weight:

| Co | Cr | Mo | W | Ta | Al | Ti | Ni |
|---|---|---|---|---|---|---|---|
| 4.6 | 7.8 | 0.5 | 8.0 | 6.0 | 5.6 | 1.0 | Bal |

Subsequent metallographic tests with this alloy have proved it has a gamma prime solvus sufficiently lower than the alloy's incipient melting point to provide a practical "heat treatment window" of 22 degrees to 28 degrees C. At the same time other tests have established its phase stability and its resistance to the formation of deleterious plate-like/acicular precipitates during long term exposure at high temperatures.

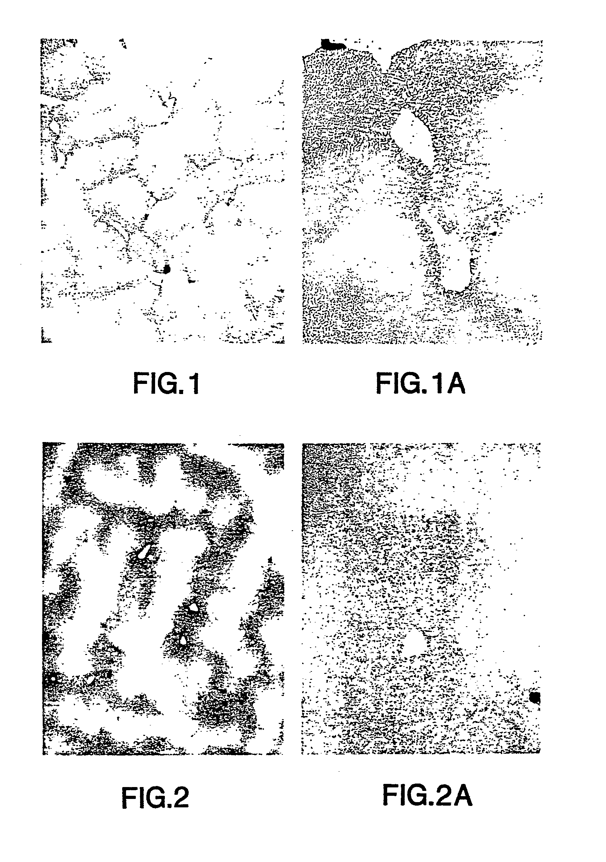

Turbine blade castings were made from this alloy using the single crystal casting technique. These castings were solution heat treated at 1315°C with a final gas fan quench, at which temperature all of the primary gamma prime went into solution, along with much of the eutectic. The change in the microstructure of the alloy is clearly shown by comparing Figures 1 and 1A with Figures 2 and 2A. It is apparent from Figure 1A taken at 400× before heat treatment that the primary gamma prime is non-uniform in both distribution and shape and is relatively large sized. After heat treatment the primary gamma prime has been rendered small and basically uniform in both size and shape. The gas fan quench results in the very fine gamma prime size of 0.2—0.3 µm. The result is a casting of uniform very fine gamma prime structure capable of developing and maintaining its maximum potential of strength and durability under high thermal/stress environments.

The experimentation which has been done to date indicates the following to be the composition range in which this alloy can be made:

TABLE I
Expressed as percentage of weight

| | Min. | Max. | Optimum |
|---|---|---|---|
| Co | 4.3 | 4.9 | 4.6 |
| Cr | 7.5 | 8.2 | 7.8 |
| Mo | 0.3 | 0.7 | 0.5 |
| W | 7.6 | 8.4 | 8.0 |
| Ta | 5.8 | 6.2 | 6.0 |
| Al | 5.45 | 5.75 | 5.6 |
| Ti | 0.8 | 1.2 | 1.0 |
| Ni | Bal | Bal | Bal |
| C | 60 ppm max. | | |
| Zr | 50 ppm max. | | |
| Hf | 50 ppm max. | | |
| B | 30 ppm max. | | |
| S | 20 ppm max. | | |
| Si | 400 ppm max. | | |

It will be seen from Table I that the alloy of this invention is very narrow in composition range and any variation from this narrow range could lead to substantial loss of functional characteristics. While it would be desirable to totally eliminate the C, Zr, Hf, B and S elements, this is impractical because they become incorporated in trace amounts either as impurities with the primary elements or from the equipment used in processing the alloy such as the lining of melting furnaces and like vessels which must necessarily be used in making and handling the alloy.

Thus the invention consists, according to one of its aspects, in a nickel base alloy for casting, as a single crystal, products to be used under high stress, high temperature conditions in an oxidizing environment and consisting, apart from incidental impurities, of the elements in the range of proportions in the above Table I and the balance Ni. The invention also consists, according to a second aspect in a method for producing a turbine engine blade wherein an alloy according to the first aspect is cast as a single crystal.

Example I

Single crystal, solid jet engine turbine blades having a section thickness of 3.175 mm were cast using the Jetshapes exothermic process from an alloy from Heat VF-267 within the range set out in Table I. This alloy had a practical "heat treatment window" of 22 to 28 degrees C and an incipient melting point of 1329.4°—1332.2°C. These blades were heat treated at the Vac Hyde Process Corp. Los Angeles, California. They were solutioned three hours at 1315°C and then gas fan quenched, treated five hours at 982°C followed by twenty hours at 871°C.

At Joliet Metallurgical Labs. specimens 1.778 mm in diameter were machined from the longitudinal direction ((001) crystallographic orientation) of the blade. These were then tested for high temperature stress-rupture with the following results:

4

| Specimen No. | Test conditions | Time to failure in hours |
|:---:|:---:|:---:|
| 1. | 5.58 kg/cm² at 982°C | 72.7 |
| 2. | 5.58 kg/cm² at 982°C | 69.2 |
| 3. | 2.79 kg/cm² at 1093°C | 98.2 |
| 4. | 2.79 kg/cm² at 1093°C | 97.6 |
| 5. | 5.58 kg/cm² at 982°C* | 69.9 |
| 6. | 5.58 kg/cm² at 982°C* | 69.9 |
| 7. | 8.53 kg/cm² at 871°C | 529.1 |
| 8. | 8.53 kg/cm² at 871°C | 498.7 |

* 20 hour 871°C aging cycle deleted.

Microscopic examination of the specimens taken from blades cast from the same heat disclosed the same uniform fine gamma prime structure shown in Figures 2 and 2A.

Example II

From the same heat (VF-267) as Example I, 9.525 mm diameter, single crystal bars were cast using a European withdrawal process. Specimens 2.26 mm diameter were machined from the longitudinal section ((001) crystallographic orientation) after a solution heat treatment of three hours at 1315°C, then air cooled and treated five hours at 982°C and an additional twenty hours at 871°C to age. These were then tested for high temperature stress-rupture with the following results:

| Specimen No. | Test conditions | Time to failure in hours |
|:---:|:---:|:---:|
| 1. | 16.41 kg/cm² at 760°C | 781 |
| 2. | 16.41 kg/cm² at 760°C | 882 |
| 3. | 16.41 kg/cm² at 760°C | 708 |
| 4. | 11.24 kg/cm² at 850°C | 263 |
| 5. | 11.24 kg/cm² at 850°C | 252 |
| 6. | 11.24 kg/cm² at 850°C | 228 |
| 7. | 2.88 kg/cm² at 1040°C | 388 |
| 8. | 2.88 kg/cm² at 1040°C | 378 |
| 9. | 2.88 kg/cm² at 1040°C | 420 |

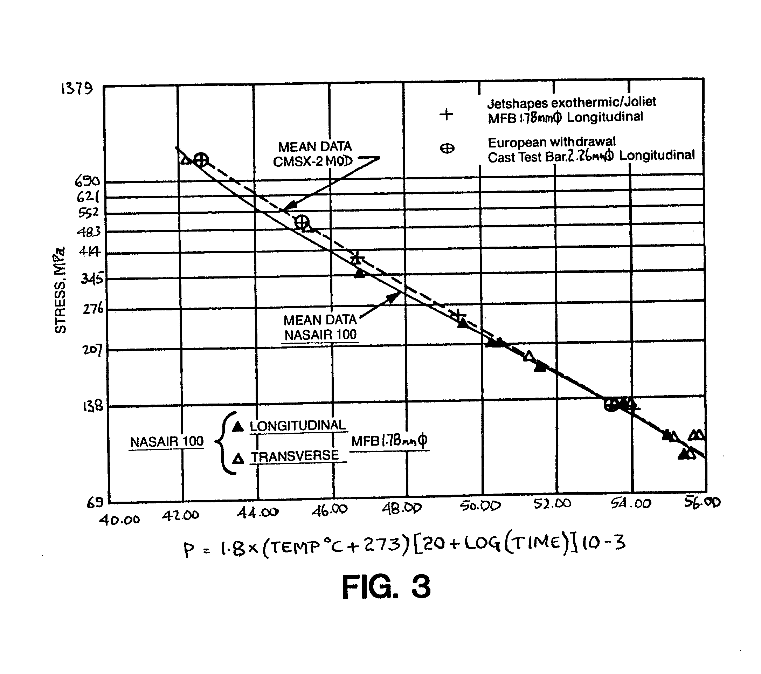

The results of the tests reported in the two preceding examples are compared graphically in Figure 3 with similar tests performed on the NasAir 100 alloy. It is apparent from these tests that the alloy of this invention has a small improvement in stress-rupture strength over NasAir 100. However, it retains the wide "heat treatment window" without loss of alloy stability. Single crystal specimens of the alloy, in the as-cast condition have been aged for 1000 hours at 850°C, 949°C and 1049°C. Microscopic examination of all the aged specimens revealed no phase instability.

Similar tests were conducted on two additional heats (VF-312 and VF-332) with similar results, confirming the repeatability of results using this alloy.

It will be recognized that this is an alloy which must be both manufactured and cast under high vacuum conditions. This is essential to avoid gaseous contaminants such as oxygen and nitrogen. It is also essential to use specialized vessels to prevent contamination from such materials as C, B, Si, Zr and others which will enter an alloy from its container.

The invention provides the first microstructurally stable, single crystal alloy having heat treat "window" characteristics which make it possible to obtain satisfactory castings without an excessive rejection rate. As such, this invention makes very high performance, single crystal (single grain) castings a practical and producible product rather than a product too costly for all but the most exotic applications.

**Claims**

1. A nickel base alloy for casting, as a single crystal, products to be used under high stress, high temperature conditions in an oxidizing environment and consisting, apart from incidental impurities, of the following elements in the following range of proportions expressed as percentages of weight:

| | |
|---|---|
| Co | 4.3—4.9 |
| Cr | 7.5—8.2 |
| Mo | 0.3—0.7 |
| W | 7.6—8.4 |
| Ta | 5.8—6.2 |
| Al | 5.45—5.75 |
| Ti | 0.8—1.2 |

and of the following elements in the proportion of parts per million:

| | |
|---|---|
| C | 0—60 |
| Zr | 0—50 |
| Hf | 0—50 |
| B | 0—30 |
| S | 0—20 |
| Si | 0—400 |

and the balance Ni.

2. An alloy as claimed in Claim 1 in which the following elements have the following proportions expressed as percentages of weight:

| | |
|---|---|
| Co | 4.6 |
| Cr | 7.8 |
| Mo | 0.5 |
| W | 8.0 |
| Ta | 6.0 |
| Al | 5.6 |
| Ti | 1.0 |
| Ni | Bal |

6

# 0 052 911

3. Method for producing a turbine engine blade wherein an alloy as claimed in Claim 1 or Claim 2 is cast as a single crystal.

4. Method as claimed in Claim 3 wherein after casting the blade is heat treated at a temperature between 1307°C and 1329°C.

5. Method as claimed in Claim 4 wherein the heat treatment at the said temperature is continued for three hours.

6. Method as claimed in Claim 3 wherein, after casting, the blade is solution treated at 1315°C for three hours and then gas fan quenched.

**Patentansprüche**

1. Einkristalline Nickel-Gießlegierung für Produkte, die unter hohen Temperaturen in oxidierender Umgebung hochbeansprucht sind, bestehend aus, abgesehen von zufälligen Verunreinigungen, den folgenden Elementen in der folgenden Reihenfolge von Anteilen in Gewichtsprozent:

| | |
|---|---|
| Co | 4.3—4.9 |
| Cr | 7.5—8.2 |
| Mo | 0.3—0.7 |
| W | 7.6—8.4 |
| Ta | 5.8—6.2 |
| Al | 5.45—5.75 |
| Ti | 0.8—1.2, |

und aus den folgenden Elemente in ppm (parts per million):

| | |
|---|---|
| C | 0—60 |
| Zr | 0—50 |
| Hf | 0—50 |
| B | 0—30 |
| S | 0—20 |
| Si | 0—400 |

Rest Ni.

2. Legierung nach Anspruch 1, bei welcher die folgenden Elemente die folgenden in Gewichtsprozent angegebenen Anteile aufweisen:

| | |
|---|---|
| Co | 4.6 |
| Cr | 7.8 |
| Mo | 0.5 |
| W | 8.0 |
| Ta | 6.0 |
| Al | 5.6 |
| Ti | 1.0 |

Rest Ni.

3. Verfahren zum Herstellen einer Turbinenschaufel, bei dem eine in Anspruch 1 oder 2 beanspruchte Legierung als Einkristall vergossen wird.

7

# 0 052 911

4. Verfahren nach Anspruch 3, dadurch gekennzeichnet, daß nach dem Gießen der Schaufel diese bei einer Temperatur zwischen 1307°C und 1329°C wärmebehandelt wird.

5. Verfahren nach Anspruch 4, dadurch gekennzeichnet, daß die Wärmebehandlung bei der genannten Temperatur über drei Stunden fortgesetzt wird.

6. Verfahren nach Anspruch 3, dadurch gekennzeichnet, daß die Schaufel nach dem Gießen bei einer Temperatur von 1315°C drei Stunden lang wärmebehandelt und anschließend im Gasstrom abgeschreckt wird.

## Revendications

1. Alliage à base de nickel pour la coulée à l'état monocristalllin de produits à utiliser dans des conditions de contrainte élevée et de haute température en milieu oxydant et consistant, outre les impuretés accidentelles, en les éléments suivants dans l'intervalle ci-après de proportions exprimées en pourcentages pondéraux:

| | |
|---|---|
| Co | 4,3—4,9 |
| Cr | 7,5—8,2 |
| Mo | 0,3—0,7 |
| W | 7,6—8,4 |
| Ta | 5,8—6,2 |
| Al | 5,45—5,75 |
| Ti | 0,8—1,2 |

et en les éléments suivants en les proportions exprimées en parties par million:

| | |
|---|---|
| C | 0—60 |
| Zr | 0—50 |
| Hf | 0—50 |
| B | 0—30 |
| S | 0—20 |
| Si | 0—400 |

et pour le reste en nickel.

2. Alliage suivant la revendication 1, dans lequel les éléments suivants ont les proportions ci-après, exprimées en pourcentages pondéraux:

| | |
|---|---|
| Co | 4,6 |
| Cr | 7,8 |
| Mo | 0,5 |
| W | 8,0 |
| Ta | 6,0 |
| Al | 5,6 |
| Ti | 1,0 |
| Ni | reste. |

3. Procédé de fabrication d'une ailette de turbine à gaz, dans lequel on coule à l'état de monocristal un alliage suivant la revendication 1 ou 2.

8

4. Procédé suivant la revendication 3, dans lequel, après la coulée, on soumet l'ailette à un traitement thermique à une température entre 1.307°C et 1.329°C.

5. Procédé suivant la revendication 4, dans lequel on poursuit pendant 3 heures le traitement thermique à cette température.

6. Procédé suivant la revendication 3, dans lequel, après la coulée, on soumet l'ailette à une traitement de mise en solution solide à 1.315°C pendant 3 heures, puis on la refroidit dans un flux de gaz.

0 052 911

FIG.1

FIG.1A

FIG.2

FIG.2A

1

FIG. 3